# EUROPÄISCHE PATENTSCHRIFT

(11) **EP 3 033 756 B1**
(45) Veröffentlichungstag und Bekanntmachung des Hinweises auf die Patenterteilung: **29.08.2018**
(21) Anmeldenummer: 14741642.4
(22) Anmeldetag: 22.07.2014
(51) Int. Cl.: H01L 41/293, H01G 4/232, H01L 41/047, H01L 41/083, H01G 4/30

(54) **VERFAHREN ZUR HERSTELLUNG EINES VIELSCHICHTBAUELEMENTS MIT EINER AUSSENKONTAKTIERUNG**
METHOD FOR PRODUCING A MULTILAYER COMPONENT COMPRISING AN EXTERNAL CONTACT
PROCEDE DE FABRICATION D'UN COMPOSANT MULTICOUCHE COMPORTANT UN ELEMENT DE MISE EN CONTACT EXTERIEUR

(30) Priorität: 13.08.2013 DE 102013108753
(43) Veröffentlichungstag der Anmeldung: 22.06.2016
(73) Patentinhaber: Epcos AG, 81671 München (DE)
(72) Erfinder: GALLER, Martin, A-8401 Kalsdorf (AT); OTTLINGER, Marion, A-8530 Deutschlandsberg (AT)
(74) Vertreter: Epping - Hermann - Fischer
(86) Internationale Anmeldenummer: PCT/EP2014/065746
(87) Internationale Veröffentlichungsnummer: WO 2015/022154

(56) Entgegenhaltungen:
- EP-A1- 1 732 146
- EP-A1- 1 780 813
- DE-A1-102005 027 364
- DE-A1-102008 056 746
- DE-A1-102010 044 326

## Beschreibung

Verfahren zur Herstellung eines Vielschichtbauelements mit einer Außenkontaktierung.

Es wird ein Vielschichtbauelement mit einer Außenkontaktierung angegeben. Beispielsweise ist das Vielschichtbauelement ein Piezoaktor, der zum Betätigen eines Einspritzventils in einem Kraftfahrzeug eingesetzt werden kann. Alternativ kann das Vielschichtbauelement beispielsweise ein Vielschichtkondensator oder ein Vielschichtvaristor sein.

Zur Kontaktierung eines Vielschichtbauelements wird beispielsweise ein Anschlusselement mit einem Grundkörper verlötet, verklebt oder verschweißt. Bei einer derartigen Befestigung kann jedoch die Kontaktierung Einfluss auf die Bewegungen des Aktors nehmen. Zudem kann die Kontaktierung durch die oftmalige Auslenkung des Aktors beschädigt werden.

EP 1 780 813 A1 und EP 1 732 146 zeigen ein Verfahren, Anschlusselemente an einem Vielschichtbauelement zu befestigen, indem diese in einer Silber-Glas- oder Silber-Harz-Paste bei geringen Temperaturen gesintert werden. 1

Es ist eine zu lösende Aufgabe, ein verbessertes Verfahren zur Herstellung eines Vielschichtbauelement anzugeben. Anspruch 1 spezifiziert das Verfahren der Erfindung.

Es wird ein Vielschichtbauelement angegeben, aufweisend einen Grundkörper und eine Außenkontaktierung. Die Außenkontaktierung weist ein Anschlusselement und eine Kontaktschicht auf. Die Kontaktschicht verbindet den Grundkörper elektrisch leitend mit dem Anschlusselement. Eine Verbindung zwischen dem Grundkörper und dem Anschlusselement ist durch ein Sintern der Kontaktschicht hergestellt.

Die Temperatur beim Sintern beträgt vorzugsweise weniger als 400°C. Beispielsweise ist die Kontaktschicht bei 250°C gesintert.

Die gesinterte Kontaktschicht weist ein polykristallines Gefüge auf. Insbesondere sind in der gesinterten Kontaktschicht Körner und Korngrenzen ausgebildet. Vorzugsweise sind in der gesinterten Kontaktschicht Poren und/oder Sinterhälse ausgebildet. Die Poren und/oder Sinterhälse sind beispielsweise zwischen Metallpartikeln, beziehungsweise zwischen Körnern ausgebildet.

Eine gesinterte Kontaktschicht hat den Vorteil, dass sie eine hohe elektrische Leitfähigkeit aufweist. Zudem weist eine gesinterte Kontaktschicht eine hohe thermische Leitfähigkeit auf. Insbesondere weist eine gesinterte Kontaktschicht eine höhere elektrische Leitfähigkeit und eine höhere thermische Leitfähigkeit auf als beispielsweise Lote, insbesondere Weichlote. Des Weiteren zeigt die gesinterte Kontaktschicht bei hohen Temperaturen eine geringe Materialermüdung. Insbesondere finden nur eine geringe plastische Umformung der Kontaktschicht und ein geringes Risswachstum in der Kontaktschicht statt. Dies ist durch einen hohen Schmelzpunkt der Kontaktschicht im Vergleich zu Loten begründet. Auch bei mechanischer oder thermomechanischer Wechsellast tritt nur eine geringe Materialermüdung der Kontaktschicht ein.

Aufgrund des relativ hohen Schmelzpunktes der Kontaktschicht können Vielschichtbauelemente mit einer derartigen Kontaktschicht in einem Reflowprozess auf Platinen aufgelötet werden.

Das Sintern der Kontaktschicht kann ohne Verwendung von Flussmitteln stattfinden. Daher ist auch kein Waschprozess zum Entfernen von Flussmittelresten notwendig, wie beispielsweise beim Löten.

Die Prozesstemperatur beim Sintern der Kontaktschicht ist deutlich geringer als beim Hartlöten oder beim Einbrennen von Metallpasten. Dadurch ist die Thermospannung im Prozess relativ niedrig und der Prozess ist einfacher und kostengünstiger.

Gemäß einer Ausführungsform ist die Kontaktschicht porös. Vorzugsweise weist die Kontaktschicht eine Porosität zwischen 1 Volumenprozent und 50 Volumenprozent auf.

Aufgrund der Porosität der Kontaktschicht ist der Elastizitätsmodul der Kontaktschicht geringer als bei dichten Metallschichten. Dadurch können Klemmeffekte und mechanische Spannungen im Keramikkörper gesenkt werden.

Die Kontaktschicht weist ein Metall auf. Die Kontaktschicht besteht vorzugsweise aus Silber oder Kupfer. Insbesondere besteht die Kontaktschicht zu wenigstens 95 Gewichtsprozent, vorzugsweise zu 99 Gewichtsprozent, aus reinem Silber oder Kupfer. Insbesondere kann die Kontaktschicht zu wenigstens 99 Gewichtsprozent aus reinem Silber oder Kupfer bestehen.

Die Schmelztemperatur des Metalls der Kontaktschicht liegt über der Sintertemperatur der Kontaktschicht. Gemäß einer Ausführungsform liegt die Schmelztemperatur der Kontaktschicht über 400°C. Insbesondere weist die Kontaktschicht bei Betriebstemperaturen über 200°C eine hohe Temperaturstabilität auf.

Gemäß einer Ausführungsform weist die Kontaktschicht eine Dicke zwischen 2 µm und 200 µm auf. Vorzugsweise weist die Kontaktschicht eine Dicke zwischen 10 µm und 100 µm auf.

Der Grundkörper des Vielschichtbauelements kann einen Stapel aus dielektrischen Schichten und internen Elektrodenschichten aufweisen. Die Außenkontaktierung kann zur elektrischen Kontaktierung der internen Elektrodenschichten dienen. Der Grundkörper ist beispielsweise quaderförmig ausgebildet.

Vorzugsweise sind die dielektrischen Schichten und die internen Elektrodenschichten entlang einer Stapelrichtung gestapelt. Die Stapelrichtung entspricht vorzugsweise der Längsrichtung des Grundkörpers. Vorzugsweise sind die dielektrischen Schichten und die internen Elektrodenschichten alternierend übereinander gestapelt.

Vorzugsweise enthalten die internen Elektrodenschichten Kupfer oder bestehen aus Kupfer. Alternativ enthalten die internen Elektrodenschichten Silber-Palladium oder bestehen aus Silber-Palladium.

Die dielektrischen Schichten können ein piezoelektrisches Material aufweisen. Beispielsweise können die dielektrischen Schichten ein keramisches Material, insbesondere ein piezokeramisches Material aufweisen. Zur Herstellung des Grundkörpers können Grünfolien verwendet werden, auf die zur Bildung von internen Elektrodenschichten beispielsweise eine Metallpaste aufgebracht wird. Beispielsweise wird die Metallpaste in einem Siebdruckverfahren aufgebracht. Die Metallpaste kann Kupfer enthalten. Alternativ kann die Metallpaste Silber oder Silber-Palladium enthalten. Nach dem Aufbringen der Metallpaste werden die Folien vorzugsweise gestapelt, verpresst und gemeinsam gesintert, sodass ein monolithischer Sinterkörper entsteht. Vorzugsweise wird der Grundkörper des Bauelements durch einen monolithischen Sinterkörper gebildet, beispielsweise durch einen wie oben beschrieben hergestellten Sinterkörper.

Beispielsweise ist das Vielschichtbauelement als piezoelektrisches Bauelement, zum Beispiel als Piezoaktor, ausgebildet. Bei einem Piezoaktor dehnen sich beim Anlegen einer Spannung an die internen Elektrodenschichten zwischen den internen Elektrodenschichten angeordnete piezoelektrische Schichten aus, sodass ein Hub des Piezoaktors erzeugt wird. Das Vielschichtbauelement kann auch als ein anderes Bauelement ausgebildet sein, beispielsweise als Vielschichtkondensator. Der Vielschichtkondensator ist vorzugsweise geeignet für leistungselektronische Anwendungen mit DC-Spannungen größer 250 Volt und Einsatztemperaturen über 120°C.

Die Außenkontaktierung dient vorzugsweise zum Anlegen einer Spannung zwischen in Stapelrichtung benachbarten internen Elektrodenschichten. Insbesondere dient die Außenkontaktierung der Zuleitung von Strom zu den internen Elektrodenschichten. Beispielsweise sind zwei Außenelektroden auf gegenüberliegenden Außenseiten des Grundkörpers angeordnet. Eine Außenelektrode weist jeweils eine Kontaktschicht und ein Anschlusselement auf.

Vorzugsweise sind die internen Elektrodenschichten in Stapelrichtung abwechselnd mit einer der Außenelektroden elektrisch verbunden und von der anderen Außenelektrode elektrisch isoliert. Die Außenkontaktierung kann dabei auf die Belastungen an dem Grundkörper ausgelegt sein.

Beispielsweise wird die Elektrodenpaste so aufgebracht, dass die Elektrodenschichten in Stapelrichtung gesehen abwechselnd bis zu einer Außenseite des Stapels reichen und von der gegenüberliegenden Außenseite des Stapels beabstandet sind. Auf diese Weise können die Elektrodenschichten abwechselnd mit einer der Außenkontaktierungen elektrisch verbunden werden. Gemäß einer Ausführungsform kann zwischen einem Ende der internen Elektrodenschicht und einer Außenseite des Grundkörpers ein Luftspalt vorhanden sein. Beispielsweise kann abwechselnd jede zweite interne Elektrodenschicht mittels Ätzens zurückgesetzt sein, so dass zwischen den geätzten internen Elektrodenschichten und einer Außenseite des Grundkörpers ein Graben angeordnet ist. Zur Verbesserung der Druchbruchspannung können die Luftspalte, bzw. die Gräben mit Isoliermaterial gefüllt sein. Das Isoliermaterial kann beispielsweise ein elastomerer Werkstoff sein.

Bei einem Vielschichtbauelement mit einer durch Sintern befestigten Kontaktschicht können die Gräben nahezu vollständig mit Isoliermaterial gefüllt sein. Dies ergibt sich daraus, dass auf den Einsatz eines Flussmittels verzichtet werden kann. Dadurch können keine Flussmittelreste in den Gräben verbleiben, welche ein Befüllen der Gräben erschweren oder verhindern. Auf diese Weise kann die Durchbruchspannung des Vielschichtbauelements im Vergleich zu einem Vielschichtbauelement mit einer verlöteten Außenkontaktierung um ca. 10% erhöht sein.

Alternativ kann das Vielschichtbauelement ein vollaktives Vielschichtbauelement sein. Bei einem vollaktiven Vielschichtbauelement erstrecken sich die internen Elektrodenschichten über den gesamten Querschnitt des Grundkörpers. Zur abwechselnden Verbindung der internen Elektrodenschichten mit einer Außenkontaktierung werden die internen Elektrodenschichten auf einer Außenseite alternierend mit elektrisch isolierendem Material bedeckt.

Vorzugsweise sind die internen Elektrodenschichten in Stapelrichtung abwechselnd mit einer der Außenelektroden elektrisch verbunden und von der anderen Außenelektrode elektrisch isoliert.

Die Außenkontaktierung ist beispielsweise streifenförmig ausgebildet. Vorzugsweise verläuft die Außenkontaktierung entlang der Stapelrichtung des Grundkörpers. Beispielsweise bedeckt die Außenkontaktierung eine Außenseite des Grundkörpers nur teilweise. Alternativ kann die Außenkontaktierung eine Außenseite des Grundkörpers vollständig bedecken.

Die Anschlusselemente können die Form eines ebenen Körpers oder die Form eines dreidimensional strukturierten Körpers haben. Ein ebener Körper kann beispielsweise die Form eines Blechs, eines Mäanders, eines Kamms oder einer Leiter aufweisen. Ein dreidimensional strukturierter Körper kann beispielsweise die Form eines Drahtgeflechts, eines Drahtgewirks oder eines Wellblechs aufweisen.

Die Anschlusselemente erstrecken sich vorzugsweise über die gesamte Länge des Vielschichtbauelements. Dadurch kann eine zuverlässige Kontaktierung auch bei einer Unterbrechung der Kontaktschicht während des Betriebs stets eine Gesamtanbindung des Bauteils garantiert sein.
Gemäß einer Ausführungsform ist zwischen dem Grundkörper und der Kontaktschicht zusätzlich eine Grundmetallisierung aufgebracht. Die Grundmetallisierung kann durch Einbrennen einer Metallpaste gebildet sein. Insbesondere kann die Grundmetallisierung durch Sintern an die Kontaktschicht angebunden sein. Der Grundmetallisierung kann eine Glaspaste zugesetzt sein. Alternativ kann die Grundmetallisierung durch Sputtern von Metallschichten auf den Grundkörper aufgebracht sein und durch Sintern an die Kontaktschicht angebunden sein. Dementsprechend kann die Grundmetallisierung lediglich aus einer aufgesputterten Schicht bestehen. Alternativ kann die Grundmetallisierung eine durch Einbrennen einer Metallpaste und durch eine zusätzliche Sputterschicht zwischen der eingebrannten Metallpaste und der Kontaktschicht gebildet sein.

Des Weiteren wird ein Verfahren zur Herstellung eines Vielschichtbauelements angegeben. Das Verfahren umfasst in einem ersten Schritt das Bereitstellen eines Grundkörpers und eines Anschlusselements. Anschließend wird eine Metallpaste auf mindestens eine Außenseite des Grundkörpers aufgetragen. Das Anschlusselement wird auf der Metallpaste positioniert. Insbesondere kann das Anschlusselement zumindest teilweise in die Metallpaste hinein gedrückt werden. Anschließend erfolgt das Sintern der Metallpaste. Das Sintern erfolgt bei einer Temperatur unterhalb 400°C. Dadurch wird das Anschlusselement mit dem Grundkörper elektrisch leitend verbunden.

Diese Metallpaste kann Metallpartikel und Organikmaterial als Lösungsmittel und Coating-Material der Feststoffe enthalten. Die Metallpartikel sind beispielsweise Silber- oder Kupferpartikel. Die Metallpaste enthält ein Salz in Form von Silberkarbonat.

Das Auftragen der Metallpaste erfolgt beispielsweise mit einer Schablone. Die aufgetragene Schicht der Metallpaste ist vorzugsweise 1 mm breit und 100 µm dick.

Die Kontaktschicht wird getrocknet und gesintert. Beispielsweise wird die Metallpaste bei 160°C 75 Minuten entbindert und danach 105 Minuten bei 250°C gesintert. Das Sintern kann unter Druck oder drucklos erfolgen.

Nach dem Sinterprozess liegt die Kontaktschicht als feste, poröse, reine Metallschicht vor. Der Grundkörper und die Außenkontaktierung sind an die Kontaktschicht fest angebunden.

Während des Sinterprozesses wird die Metallpaste zur porösen Kontaktschicht umgewandelt.

Im Folgenden wird die Erfindung anhand von schematischen, nicht maßstabsgetreuen Figuren erläutert.

Es zeigen:
- Figur 1: eine Schnittdarstellung eines Vielschichtbauelements,
- Figur 2: eine Seitenansicht des Vielschichtbauelements aus Figur 1.

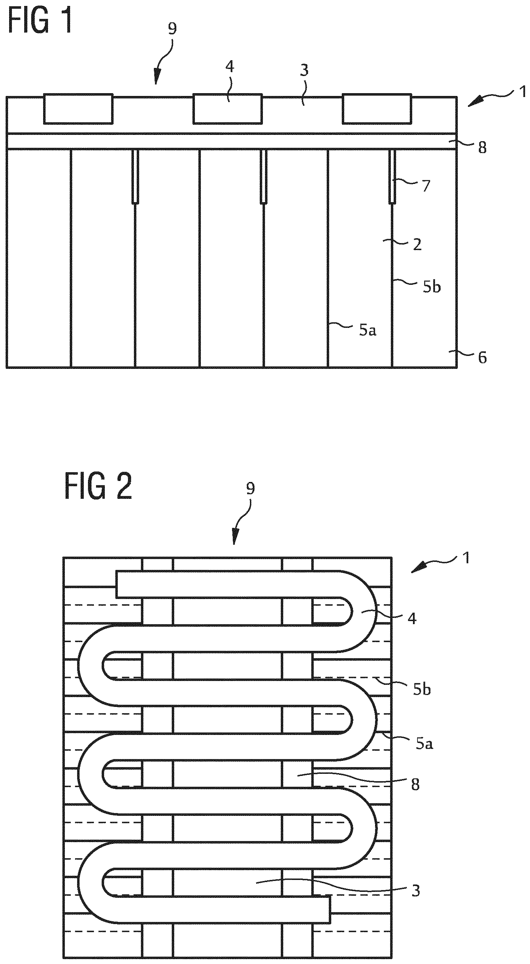

Figur 1 zeigt ein Vielschichtbaulement 1 in einer Schnittdarstellung.

Das Vielschichtbauelement 1 weist einen Grundkörper 2 auf. Der Grundkörper 2 weist alternierend angeordnete erste und zweite interne Elektrodenschichten 5a, 5b und piezoelektrische Schichten 6 auf.

Auf einer Außenseite des Grundkörpers 2 ist eine Außenkontaktierung 9 aufgebracht. Die Außenkontaktierung 9 weist eine Kontaktschicht 3 und ein Anschlusselement 4 auf. Die Kontaktschicht 3 ist porös. Zudem weist die Außenkontaktierung 9 eine Grundmetallisierung 8 auf. Die Grundmetallisierung 8 kann beispielsweise eine eingebrannte Metallschicht und/oder eine Sputterschicht aufweisen. Die eingebrannte Metallschicht kann einen Glaszusatz aufweisen.

Jede erste interne Elektrodenschicht 5a erstreckt sich bis zu der Außenseite des Grundkörpers 2, und ist dort durch die Außenkontaktierung 9 kontaktiert. Jede zweite interne Elektrodenschicht 5b ist von der Außenseite des Grundkörpers 2 beabstandet. Insbesondere ist zwischen jeder zweiten internen Elektrodenschicht 5b und der Außenseite des Grundkörpers eine Isolationszone 7 angeordnet. Die Isolationszone 7 kann als Luftspalt ausgebildet sein. Alternativ kann die Isolationszone 7 mit einem Isoliermaterial gefüllt sein.

Wie in Figur 1 ersichtlich ist, ist das Anschlusselement 4 zumindest teilweise in die Kontaktschicht 3 eingebettet. Dadurch ist eine zuverlässige Verbindung zwischen dem Anschlusselement 4 und der Kontaktschicht 3 hergestellt.

Figur 2 zeigt das Vielschichtbauelement 1 in einer Seitenansicht. Dabei ist jede zweite interne Elektrodenschicht 5b, welche durch eine Isolationszone 7 von der Außenseite des Grundkörpers 2 beabstandet ist, gestrichelt dargestellt. Auf einer gegenüberliegenden Außenseite des Grundkörpers erstrecken sich die zweiten internen Elektrodenschichten 5b bis zur Außenseite des Grundkörpers 2, während die ersten internen Elektrodenschichten 5a durch eine Isolationszone 7 von dieser beabstandet sind.

Die Grundmetallisierung 8 und die Kontaktschicht 3 sind in Form eines Streifens ausgebildet, wobei die Grundmetallisierung 8 etwas breiter ist als die Kontaktschicht 3.

Das in Figur 2 gezeigte Anschlusselement 4 ist mäanderförmig ausgebildet. Das Anschlusselement 4 kann jedoch auch andere Formen aufweisen, beispielsweise die einer Leiter, eines Blechs oder Wellblechs, eines Drahtsiebs oder eines Kamms.

### Bezugszeichen

- 1: Vielschichtbauelement
- 2: Grundkörper
- 3: Kontaktschicht
- 4: Anschlusselement
- 5a: interne Elektrodenschicht
- 5b: interne Elektrodenschicht
- 6: piezoelektrische Schicht
- 7: Isolationszone
- 8: Grundmetallisierung
- 9: Außenkontaktierung

## Patentansprüche

1. Verfahren zur Herstellung eines Vielschichtbauelements (1), umfassend folgende Schritte:
A) Bereitstellen eines Grundkörpers (2) und eines Anschlusselements (4),
B) Auftragen einer Metallpaste auf mindestens einer Außenseite des Grundkörpers (2), wobei die Metallpaste Silberkarbonat aufweist,
C) Platzieren des Anschlusselements (4) auf der Metallpaste,
D) Sintern der Metallpaste und dadurch elektrisch leitendes Verbinden des Anschlusselements (4) mit dem Grundkörper (2).

2. Verfahren nach dem vorhergehenden Anspruch, wobei das Sintern bei einer Temperatur unterhalb 400°C erfolgt.

3. Verfahren nach einem der beiden vorhergehenden Ansprüche, wobei die Metallpaste während des Sintervorgangs zu einer porösen Kontaktschicht (3) wird.

4. Verfahren nach dem vorhergehenden Anspruch, wobei die Porosität der Kontaktschicht (3) zwischen 1 Volumen-% und 50 Volumen-% liegt.

5. Verfahren nach einem der vorhergehenden Ansprüche, wobei die Kontaktschicht (3) ein Metall enthält.

6. Verfahren nach einem der vorhergehenden Ansprüche, wobei die Kontaktschicht (3) Silber oder Kupfer enthält.

7. Verfahren nach einem der vorhergehenden Ansprüche, wobei die Kontaktschicht (3) aus einem zu mindestens 95 % reinem Stoff besteht.

8. Verfahren nach einem der vorhergehenden Ansprüche, wobei die Dicke der Kontaktschicht (3) zwischen 2 µm und 200 µm liegt.

9. Verfahren nach einem der vorhergehenden Ansprüche, wobei die Kontaktschicht (3) eine Schmelztemperatur von über 400°C aufweist.

10. Verfahren nach einem der vorhergehenden Ansprüche, wobei zwischen dem Grundkörper (2) und der Kontaktschicht (3) zusätzlich eine Grundmetallisierung (8) aufgebracht ist.

11. Verfahren nach einem der vorhergehenden Ansprüche, wobei das Anschlusselement (4) die Form eines Mäanders, eines Kamms, eines Blechs, eines Drahtgeflechts, eines Drahtgewirks, einer Leiter oder eines Wellblechs hat.

12. Verfahren nach einem der vorhergehenden Ansprüche, wobei das Vielschichtbauelement (1) als Piezoaktuator oder als Vielschichtkondensator ausgebildet ist.

## Claims

1. Method for producing a multilayer component (1), comprising the following steps:
A) providing a main body (2) and a connection element (4),
B) applying a metal paste on at least one outer side of the main body (2), wherein the metal paste comprises silver carbonate,
C) positioning the connection element (4) on the metal paste,
D) sintering the metal paste and thereby electrically conductively connecting the connection element (4) to the main body (2).

2. Method according to the preceding claim, wherein the sintering is carried out at a temperature below 400°C.

3. Method according to either of the two preceding claims, wherein the metal paste becomes a porous contact layer (3) during the sintering process.

4. Method according to the preceding claim, wherein the porosity of the contact layer (3) is between 1% by volume and 50% by volume.

5. Method according to any of the preceding claims, wherein the contact layer (3) contains a metal.

6. Method according to any of the preceding claims, wherein the contact layer (3) contains silver or copper.

7. Method according to any of the preceding claims, wherein the contact layer (3) consists of a substance that is pure to the extent of at least 95%.

8. Method according to any of the preceding claims, wherein the thickness of the contact layer (3) is between 2 µm and 200 µm.

9. Method according to any of the preceding claims, wherein the contact layer (3) has a melting point of above 400°C.

10. Method according to any of the preceding claims, wherein a base metallization (8) is additionally applied between the main body (2) and the contact layer (3).

11. Method according to any of the preceding claims, wherein the connection element (4) has the form of a meander, a comb, a metal sheet, a wire braiding, a knitted wire mesh, a conductor or a corrugated metal sheet.

12. Method according to any of the preceding claims, wherein the multilayer component (1) is embodied as a piezoactuator or as a multilayer capacitor.

## Revendications

1. Procédé de fabrication d'un composant multicouche (1), comprenant les étapes suivantes :
A) fourniture d'un corps de base (2) et d'un élément de raccordement (4),
B) application d'une pâte de métal au moins sur un côté extérieur du corps de base (2), la pâte de métal possédant du carbonate d'argent,
C) placement de l'élément de raccordement (4) sur la pâte de métal,
D) frittage de la pâte de métal et ainsi connexion électriquement conductrice de l'élément de raccordement (4) au corps de base (2).

2. Procédé selon la revendication précédente, le frittage étant effectué à une température inférieure à 400 °C.

3. Procédé selon l'une des deux revendications précédentes, la pâte de métal devenant une couche de contact (3) poreuse pendant l'opération de frittage.

4. Procédé selon la revendication précédente, la porosité de la couche de contact (3) étant comprise entre 1 % volumique et 50 % volumiques.

5. Procédé selon l'une des revendications précédentes, la couche de contact (3) contenant un métal.

6. Procédé selon l'une des revendications précédentes, la couche de contact (3) contenant de l'argent ou du cuivre.

7. Procédé selon l'une des revendications précédentes, la couche de contact (3) étant constituée d'une matière pure à au moins 95 %.

8. Procédé selon l'une des revendications précédentes, l'épaisseur de la couche de contact (3) étant comprise entre 2 µm et 200 µm.

9. Procédé selon l'une des revendications précédentes, la couche de contact (3) possédant une température de fusion supérieure à 400 °C.

10. Procédé selon l'une des revendications précédentes, une métallisation de base (8) étant appliquée ente le corps de base (2) et la couche de contact (3).

11. Procédé selon l'une des revendications précédentes, l'élément de raccordement (4) ayant la forme d'un méandre, d'un peigne, d'une tôle, d'un treillis, d'un tricot métallique, d'un conducteur ou d'une tôle ondulée.

12. Procédé selon l'une des revendications précédentes, le composant multicouche (1) étant réalisé sous la forme d'un actionneur piézoélectrique ou d'un condensateur multicouche.
